**Europäisches Patentamt**

**European Patent Office**

**Office européen des brevets**

(11) Veröffentlichungsnummer: **0 317 877 B1**

(12) # EUROPÄISCHE PATENTSCHRIFT

(45) Veröffentlichungstag der Patentschrift: **23.12.92**

(51) Int. Cl.⁵: **C04B 35/00**, H01L 39/12

(21) Anmeldenummer: **88119013.6**

(22) Anmeldetag: **15.11.88**

(54) **Supraleiter und Verfahren zu seiner Herstellung.**

(30) Priorität: **25.11.87 DE 3739886**

(43) Veröffentlichungstag der Anmeldung:
**31.05.89 Patentblatt 89/22**

(45) Bekanntmachung des Hinweises auf die
Patenterteilung:
**23.12.92 Patentblatt 92/52**

(84) Benannte Vertragsstaaten:
**AT BE CH DE ES FR GB GR IT LI LU NL SE**

(56) Entgegenhaltungen:
**EP-A- 0 281 474**
**EP-A- 0 287 810**

**ZEITSCHRIFT FÜR PHYSIK B-CONDENSED
MATTER, Band 68, Juli 1987, Seiten 421-423,
Springer Verlag; C. MICHEL et al.:
"Superconductivity in the Bi-Sr-Cu-O System"**

(73) Patentinhaber: **HOECHST AKTIENGESELL-
SCHAFT
Postfach 80 03 20
W-6230 Frankfurt am Main 80(DE)**

(72) Erfinder: **von Schnering, Hans-Georg, Prof.
Dr.
Theodor-Storm-Weg 7
W-7031 Aidlingen(DE)**
Erfinder: **Becker, Winfried, Dr.
Am Flachsland 1
W-6233 Kelkheim (Taunus)(DE)**
Erfinder: **Schwarz, Martin, Dr.
Le Mêle Strasse 26
W-6240 Königstein/Taunus(DE)**
Erfinder: **Walz, Leonhard, Dr.
Rappenstrasse 4
W-7550 Rastatt(DE)**
Erfinder: **Waldschmidt, Elfi
Schulstrasse 42
W-6277 Bad Camberg(DE)**
Erfinder: **Adam, Joachim
Butzbacher Strasse 14
W-6308 Butzbach(DE)**

**Beschreibung**

Die vorliegende Erfindung betrifft Hochtemperatur-supraleitende Substanzen auf Basis von Wismut, Strontium und Kupfer.

Während die konventionellen supraleitenden Materialien ausschließlich bei sehr tiefen Temperaturen eingesetzt werden konnten, die den Einsatz des sehr teuren Kühlmittels Helium erforderten, arbeiten die neuen supraleitenden oxidischen Substanzen bei wesentlich höheren Temperaturen, die mit dem vergleichsweise billigen Kühlmittel Stickstoff erreichbar sind. Hierdurch verringern sich die Betriebskosten supraleitender Geräte und Anlagen und eröffnen neue, umfassende Anwendungsmöglichkeiten.

Ein wesentlicher Nachteil vieler neuer oxidischer Supraleiter besteht allerdings darin, daß sie als eine gemeinsame Komponente La oder Y oder Seltenerdmetalle wie z.B. Sm, Lu, Ho oder Eu enthalten. Diese Metalle kommen zum Teil nur in geringen Mengen vor und sind wegen ihrer aufwendigen Gewinnung teuer. Für die Herstellung großer Mengen oxidischer Supraleiter ergeben sich somit Nachteile aus den hohen Rohstoffpreisen und den begrenzten Resourcen der Seltenerdmetalle.

Es ist bereits ein oxidischer Supraleiter mit einer Sprungtemperatur von 20 K bekannt, der in oxidischer Form die Elemente Wismut, Strontium und Kupfer im Atomverhältnis 1:1:1 enthält. (C. Michel et al., Z. Phys. B 68 (1987) 421). Eine Sprungtemperatur von etwa 20 K ist für technische Zwecke jedoch noch nicht zufriedenstellend.

Es bestand daher die Aufgabe, neue supraleitende oxidische Stoffe bereitzustellen, die keine seltenen Erdmetalle und kein Lanthan oder Yttrium enthalten und deren Sprungtemperatur deutlich oberhalb 20K liegt.

Der Erfindung liegt die Erkenntnis zugrunde, daß die Sprungtemperatur im Dreistoff-System der Oxide von Bi, Sr und Cu günstig beeinflußt wird, wenn in den oxidierten Substanzen das Atomverhältnis Bi: $(Bi + Cu + Sr)$ etwa 0,36-0,56 beträgt.

Es werden nun neue, in Anspruch 1 näher gekennzeichnete Stoffe mit Supraleitfähigkeit gefunden. Sie bestehen aus den Metallen Strontium, Kupfer und Wismut und enthalten diese in oxidischer Form. Der Gehalt an Strontium beträgt 9,8 bis 49,6 Atom-%, der Gehalt an Wismut 36 - 55,7 Atom-% und der Gehalt an Kupfer 10 - 40 Atom-%.

Die Substanzen besitzen eine kritische Temperatur (Sprungtemperatur) $T_c$ von über 20 K und vorzugsweise von mindestens 40 K. Sie sind schwarz und ihre Hauptphasen kristallisieren im orthorhombischen System.

Die neuen Substanzen weisen die allgemeine Bruttozusammensetzung $Bi_a Sr_b Cu_c O_d$ auf,

wobei $a + b + c = 1$,

$a$ = 0,36 -0,557, insbesondere 0,37 - 0,46,

$b$ = 0,098 - 0,496, insbesondere 0,14 - 0,496,

$c$ = 0,1 - 0,4 ist und

$d$ etwa $a/2 + 1$ ist.

In den Substanzen ist der Sauerstoffgehalt etwas höher als für zweiwertiges Kupfer und dreiwertiges Wismut errechnet. Daher enthalten sie wahrscheinlich auch $Cu^{+++}$-Ionen. Bei vorgegebenem a, b und c ist ein möglichst hoher Sauerstoffgehalt (d) für die Supraleitfähigkeit vorteilhaft.

Bei einer besonderen Ausführungsform der Erfindung beträgt das Atomverhältnis $(Bi + Sr):Cu$ etwa 2. Diese Substanzen weisen die allgemeine Zusammensetzung $Bi_{1,2 + x} Sr_{0,8-x} Cu_{1 + k} O_e$ auf, wobei k eine Zahl zwischen -0,05 bis +0,05, vorzugsweise aber 0 bedeutet,

x eine Zahl zwischen 0 bis 0,7 darstellt und

$e$ etwa $3,6 + k + x/2$ bedeutet.

Bevorzugte Werte für x sind 0 bis 0,4, insbesondere 0 bis 0,1.

Bei einer weiteren besonderen Ausführungsform der Erfindung beträgt das Atomverhältnis $(Sr + Cu):Bi$ etwa 1,5. Diese Substanzen besitzen die allgemeine Zusammensetzung

$$Bi_2 Sr_y Cu_{3-y + k} O_f$$

wobei k eine Zahl zwischen -0,05 bis +0,05, vorzugsweise 0 und

y eine Zahl zwischen 1 bis 2,5, vorzugsweise 1,33 bis 2,25, insbesondere 1,5 bis 2,05 und

$f$ etwa $6 + k$

bedeutet.

Die neuen Substanzen lassen sich dadurch herstellen, daß man Oxide oder Oxidvorläufer der Elemente Bi, Sr und Cu gründlich vermischt, das Gemisch auf Temperaturen von 700 bis 1100°C aufheizt und längere Zeit in diesem Temperaturbereich hält. Während der Reaktion ändert sich das Atomverhältnis der eingesetzten Metalle in erster Näherung nicht. Das verwendete Atomverhältnis entspricht daher der angestrebten Oxidzusammensetzung.

Als Oxidvorläufer lassen sich allgemein Verbindungen, die bei der Reaktionstemperatur zu den entsprechenden Oxiden reagieren, einsetzen, insbesondere die Hydroxide und Nitrate. Verwendbar sind ferner die Acetate, Formiate, Oxalate sowie Carbonate der genannten Metalle. Verwendbar sind z.B. Strontiumcarbonat, Wismutsäure, Wismut-III-oxid, Wismut-V-oxid, $Cu_2O$ und CuO.

Die Synthesetemperatur liegt vorzugsweise im Bereich zwischen 700 und 900°C, vorzugsweise 700 bis 750°C. Die Reaktionszeit soll mindestens 4 Stunden, noch besser mindestens 8 Stunden betragen. Nach oben wird die Reaktionszeit nur durch wirtschaftliche Überlegungen begrenzt. Reaktionszeiten von 100 oder 120 Stunden sind möglich.

Die eigentliche Reaktion soll in einer nicht-reduzierenden Atmosphäre stattfinden. Verwendbar sind z.B. Luft, reiner Sauerstoff, Gemische von $O_2/Ar$ oder $O_2/N_2$. Es ist bevorzugt, wenn die Umsetzung der Oxide in einer Sauerstoff enthaltenden Atmosphäre durchgeführt wird. Die Anwendung erhöhter Sauerstoff-Drucke scheint keine Vorteile zu bieten.

Mit fortschreitender Reaktion nimmt die Anzahl der Linien im Röntgenbeugungsspektrum ab. Die Reaktion ist beendet, falls keine Änderung des Spektrums mehr eintritt.

Nach beendeter Reaktion wird die Probe entweder aus dem Ofen entnommen und in Luft oder Sauerstoff (rasch) oder im Ofen langsam auf Raumtemperatur abgekühlt. Hohe Abkühlungsgeschwindigkeiten wirken sich günstig auf die supraleitenden Eigenschaften des Reaktionsprodukts aus.

Um sicherzustellen, daß sich das gesamte Oxidgemisch umgesetzt hat, ist es vorteilhaft, das erhaltene Pulver nach dem Abkühlen weiter zu zerkleinern und erneut thermisch zu behandeln. Bei dieser Nachbehandlung liegt die Temperatur im Bereich von 300 bis 900°C. Bevorzugte Untergrenzen der Temperatur der Nachbehandlung liegen bei mindestens 350°C, insbesondere 400°C, eine bevorzugte Obergrenze bei 750°C, besser 600°C, insbesondere 550°C. Die mögliche Nachreaktion soll in Luft, reinem Sauerstoff, oder einem Gasgemisch wie $O_2/Ar$ oder $O_2/N_2$ durchgeführt werden. Als Reaktionsgefäße können handelsübliche Tiegel oder Schiffchen aus inerten Materialien, wie z.B. Aluminiumoxid, Zirkon, Platin und Iridium benutzt werden. Als Wärmequelle eignen sich handelsübliche Öfen, wie z.B. Kammer-, Muffel- oder Rohröfen.

Ein weiteres Verfahren zur Herstellung der supraleitenden Substanzen besteht darin, daß man Salze der genannten Metalle in Gegenwart einer wäßrigen Phase vermischt, das wasserhaltige Salzgemisch eindampft und im Temperaturbereich von 700 bis 1100°C, vorzugsweise 700 bis 900°C tempert. Mindestens eines der eingesetzten Salze soll wasserlöslich sein und die Salze sollen sich im angegebenen Temperaturbereich zu den Oxiden zersetzen. Hinsichtlich der Reaktionszeit gilt das gleiche wie bei Verwendung der Oxide.

Das einzudampfende Salzgemisch läßt sich auch dadurch herstellen, daß man die Metalloxide in Salpetersäure löst und die Salpetersäure abraucht.

Man kann auch, soweit wasserlösliche Salze eingesetzt werden, durch Zugabe einer Base, z.B. Tetramethylammonium-Hydroxid die Metallhydroxide ausfällen. Auf diese Weise gelingt es, ein besonders gründliches Vermischen der Ausgangsprodukte zu erzielen. Die ausgefällten Hydroxide können abgetrennt, getrocknet und dann wie oben angegeben getempert werden. Vorzugsweise werden durch die verwendete Base keine schwer flüchtigen Kationen und durch die eingesetzten Salze, die sich von leicht flüchtigen Säuren ableiten, keine schwer flüchtigen Anionen eingeschleppt.

Auch bei dieser Ausgestaltung des erfindungsgemäßen Verfahrens entspricht das Atomverhältnis der eingesetzten Metallsalze dem angestrebten Atomverhältnis des Endproduktes. Die aus den Salzen hergestellten oxidischen Produkte lassen sich, wie oben beschrieben, ebenfalls thermisch nachbehandeln.

Aus der erfindungsgemäßen schwarzen Kristallmasse lassen sich nach Aufschmelzen, Abkühlen und Zermahlen unter dem Mikroskop Kristalle von $Cu_2O$ (rot) und CuO (Nadeln) entfernen. Es verbleibt eine schwarze Masse, aus der sich unter dem Mikroskop schwarze plättchenförmige Kristalle durch Auslesen isolieren lassen.

Wie die Röntgenstruktur-Analyse an diesen Einkristallen ergibt, hat diese Hauptphase die Zusammensetzung $Cu_4Bi_8Sr_8O_z$, deren Struktur eine alternierende Anordnung von Schichten parallel (001) aufweist.Eine Schicht wird von $CuO_6$-Oktaedern gebildet, die ähnlich wie ein Perowskit eckenverknüpft sind. Die zweite Schicht wird von Sauerstoff-und Wismutatomen aufgebaut. Dabei bilden die Sauerstoffatome ein zweidimensional unendliches Netz aus kantenverknüpften Quadraten. Die Wismutatome sind alternierend oberhalb und unterhalb der Quadratmitten angeordnet.

Überraschenderweise lassen sich beim erfindungsgemäßen Verfahren aus Laborchemikalien mit einer Reinheit von nur etwa 99,5 % supraleitende Substanzen gewinnen. Verwendbar sind aber auch Chemikalien mit einem Reingehalt von 99,8 %.

3

Die gewonnenen supraleitenden Substanzen lassen sich in der Energietechnik (für Kabel und Drähte, Transformatoren, und Energiespeicher in Form stromdurchflossener Spulen) in der Magnettechnologie (z.B. für Kernspintomographen und zur Herstellung von Haltemagneten für Schwebebahnen), in der Computertechnik (dünne Schichten, Verbindungen auf Leiterplatten , Josephson-Schaltelemente) und für elektronische Bauelemente (Detektoren, Antennen, Transistoren, elektronische Sensoren, z.B. SQUIDs, Galvanometer, Modulatoren, Bolometer und SLUGs) verwenden. Die Anwendung der Supraleitung in der Meßtechnik wird behandelt in dem gleichnamigen Aufsatz von Prof. F. Baumann, Karlsruhe, in einer Aufsatzreihe des VDI-Bildungswerks (1976).

Die Erfindung wird durch die Beispiele näher erläutert.

## Beispiel 1

8 mol $SrCO_3$, 6 mol $Bi_2O_3$ und 10 mol CuO werden in einem Achatmörser zerkleinert, gründlich gemischt und in einen Tiegel aus $Al_2O_3$ überführt. Die Probe wird an Luft in einem geeigneten Laborofen schnell auf 700°C erhitzt und dort 100 h gehalten, anschließend schnell auf Raumtemperatur abgekühlt. Das geglühte Pulver wird zerkleinert und unter einem Druck von etwa 300 MPa (3 kbar) zu Tabletten gepreßt. Die Formkörper werden abermals 10 Stunden lang bei 700°C unter reiner Sauerstoffatmosphäre getempert. Das so hergestellte schwarze Material zeigte bei Messungen mit einem SQUID- oder Quanteninterferometer eine Sprungtemperatur von 40 K. Aus der Stärke des Meißner-Effekts ergibt sich, daß die Phase mit der Sprungtemperatur 40 K weniger als 50 Vol-% ausmacht. Nach röntgenographischen Untersuchungen betragen die Gitterkonstanten: a = $5.397 \cdot 10^{-10}$ m, b = $5.384 \cdot 10^{-10}$ m und c = $24.415 \cdot 10^{-10}$ m.

Das Röntgenbeugungsspektrum (Strahlenquelle: Kupfer $K_\alpha$ $1.54056 \cdot 10^{-10}$ m) zeigt Linien bei folgenden d-Werten: 4,083; 3,447; 3,066; 3,025; 2,712; 2,026; 1,922; 1,913; 1,802; 1,770; 1,688; 1,672; 1,614; $1,507 \cdot 10^{-10}$ m.

## Beispiel 2

2 mol SrO (99.5 %, Fa. Alfa), 1 mol $Bi_2O_3$ (99.8 %, Fa. Ventron) und 1 mol CuO (99,0 %, Fa. Riedel de Haen ) werden in einem Achatmöser zerkleinert, gründlich gemischt und in einen Tiegel aus $Al_2O_3$ überführt. Die Probe wird an Luft innerhalb von 2 Stunden auf 800°C erhitzt, dort 7 Stunden lang gehalten und anschließend dem Ofen entnommen (bei 800°C). Das geglühte Pulver wird nach Abkühlen zerkleinert und unter einem Druck von etwa 3 kbar zu Tabletten gepreßt. Die Tabletten werden abermals in 1 Stunde in Luft auf 800°C erhitzt, dort 7 Stunden lang gehalten und anschließend dem Ofen entnommen. Das so hergestellte Material zeigte bei Vierpunkt-Leitfähigkeitsmessungen einen Übergang in den supraleitenden Zustand bei $T_c$ = 40 K und nach Untersuchung des Meißner-Effekts eine Sprungtemperatur von 52 K. Aus der Stärke des Meißner-Effekts ergibt sich, daß die Phase mit der Sprungtemperatur 40 K weniger als 50 Vol.-% ausmacht.

Die Dichte der schwarzen Kristallmasse beträgt 6.48 g/$cm^3$ (Pyknometer).

Das Röntgenbeugungsspektrum (Pulverdiagramm der Kristallmasse) ist aus der Tabelle 1 ersichtlich.

4

Tabelle 1

| NO | 2THETA | D | INTEG.I (%) | NO | 2THETA | D | INTEG.I(%) |
|---|---|---|---|---|---|---|---|
| 1 | 4.776 | 18.5011 | 0.6 | 34 | 40.309 | 2.2374 | 2.0 |
| 2 | 7.196 | 12.2644 | 2.7 | 35 | 41.113 | 2.1955 | 5.1 |
| 3 | 9.196 | 9.6169 | 18.4 | 36 | 41.617 | 2.1700 | 14.2 |
| 4 | 12.337 | 7.1742 | 13.4 | 37 | 42.258 | 2.1386 | 16.6 |
| 5 | 13.386 | 6.6144 | 1.2 | 38 | 43.692 | 2.0717 | 4.4 |
| 6 | 14.485 | 6.1149 | 3.7 | 39 | 44.944 | 2.0169 | 10.7 |
| 7 | 16.834 | 5.2666 | 2.5 | 40 | 45.861 | 1.9786 | 6.8 |
| 8 | 18.512 | 4.7928 | 33.2 | 41 | 47.734 | 1.9053 | 25.7 |
| 9 | 18.990 | 4.6731 | 21.1 | 42 | 48.952 | 1.8607 | 16.0 |
| 10 | 20.337 | 4.3667 | 2.2 | 43 | 49.250 | 1.8501 | 6.1 |
| 11 | 21.276 | 4.1760 | 4.8 | 44 | 49.756 | 1.8325 | 4.0 |
| 12 | 21.789 | 4.0768 | 6.7 | 45 | 50.662 | 1.8018 | 8.2 |
| 13 | 22.251 | 3.9951 | 1.9 | 46 | 51.301 | 1.7609 | 36.4 |
| 14 | 24.139 | 3.6868 | 30.1 | 47 | 51.795 | 1.7651 | 1.2 |
| 15 | 24.758 | 3.5960 | 3.2 | 48 | 52.226 | 1.7514 | 9.7 |
| 16 | 25.854 | 3.4459 | 54.5 | 49 | 53.099 | 1.7247 | 10.3 |
| 17 | 26.711 | 3.3373 | 12.1 | 50 | 53.823 | 1.7032 | 1.9 |
| 18 | 28.011 | 3.1854 | 100.0 | 51 | 54.565 | 1.6616 | 9.7 |
| 19 | 28.581 | 3.1231 | 3.3 | 52 | 55.183 | 1.6644 | 3.9 |
| 20 | 28.933 | 3.0860 | 42.6 | 53 | 56.054 | 1.6406 | 2.2 |
| 21 | 29.282 | 3.0499 | 14.8 | 54 | 56.798 | 1.6209 | 15.7 |
| 22 | 29.704 | 3.0076 | 34.7 | 55 | 57.406 | 1.6051 | 1.6 |
| 23 | 30.396 | 2.9406 | 27.4 | 56 | 56.490 | 1.5780 | 8.0 |
| 24 | 31.683 | 2.8241 | 9.3 | 57 | 59.170 | 1.5614 | 1.1 |
| 25 | 32.794 | 2.7309 | 1.4 | 58 | 60.021 | 1.5413 | 3.9 |
| 26 | 33.416 | 2.6814 | 47.6 | 59 | 60.710 | 1.5255 | 5.2 |
| 27 | 34.148 | 2.6256 | 3.5 | 60 | 61.844 | 1.5002 | 3.5 |
| 28 | 34.889 | 2.5716 | 5.1 | 61 | 62.697 | 1.4618 | 1.5 |
| 29 | 35.716 | 2.5139 | 18.6 | 62 | 63.576 | 1.4634 | 1.9 |
| 30 | 36.278 | 2.4762 | 2.6 | 63 | 65.593 | 1.4232 | 2.1 |
| 31 | 37.471 | 2.4001 | 2.1 | 64 | 66.536 | 1.4053 | 3.7 |
| 32 | 38.139 | 2.3595 | 9.7 | 65 | 67.462 | 1.3683 | 3.8 |
| 33 | 38.926 | 2.3136 | 23.9 | 66 | 66.466 | 1.3700 | 9.2 |
| | | | | 67 | 69.600 | 1.3508 | 2.5 |

**Patentansprüche**

**Patentansprüche für folgende Vertragsstaaten : AT, BE, CH, DE, FR, GB, GR, IT, LI, LU, NL, SE**

1. Schwarze Kristallmasse mit der Bruttozusammensetzung

$$Bi_a Sr_b Cu_c O_d$$

wobei $a+b+c = 1$,
$a = 0{,}36 - 0{,}557$, insbesondere $0{,}37 - 0{,}46$,
$b = 0{,}098 - 0{,}496$, insbesondere $0{,}14 - 0{,}496$,
$c = 0{,}1 - 0{,}4$ und
$d = $ etwa $1 + a/2$ und
einer Sprungtemperatur $T_c$ für die Supraleitfähigkeit von über 20 K und einer Hauptphase. die im orthorhombischen System kristallisiert.

2. Kristallmasse gemäß Anspruch 1, gekennzeichnet durch die Bruttozusammensetzung $Bi_{1{,}2+x} Sr_{0{,}8-x} Cu_{1+k} O_e$, wobei
$k$ eine Zahl zwischen $-0{,}05$ bis $+0{,}05$,

x eine Zahl zwischen 0 bis 0,7 und

e etwa $3,6 + k + x/2$ ist.

3. Kristallmasse gemäß Anspruch 2, dadurch gekennzeichnet, daß $k = 0$ ist.

4. Kristallmasse gemäß Anspruch 1, gekennzeichnet durch die Bruttozusammensetzung $Bi_2Sr_yCu_{3-y+k}O_f$, wobei

k eine Zahl zwischen -0,05 und +0,05 und

y eine Zahl zwischen 1 bis 2,5, vorzugsweise 1,33 bis 2,25 und

f etwa $6 + k$ bedeutet.

5. Kristallmasse gemäß Anspruch 4, wobei y eine Zahl zwischen 1,5 bis 2,05 bedeutet.

6. Kristallmasse nach Anspruch 4, dadurch gekennzeichnet, daß $k = 0$ ist.

7. Verfahren zur Herstellung eines supraleitenden Produktes mit einer Sprungtemperatur $T_c$ über 20 K, wobei man die Oxide von Wismut, Strontium und Kupfer oder entsprechende Oxidvorläufer vermischt, das Gemisch auf Temperaturen von 700-1100°C aufheizt und längere Zeit in diesem Temperaturbereich hält, dadurch gekennzeichnet, daß das eingesetzte Gemisch, bezogen auf den Metallanteil, 36-55,7 Atom-% Wismut, 9,8-49,6 Atom-% Strontium und 10-40 Atom-% Kupfer enthält, wobei die Summe dieser Anteile 100 % beträgt.

8. Verfahren nach Anspruch 7, dadurch gekennzeichnet, daß man zur Herstellung eines Gemisches der Oxidvorläufer Salze von Wismut, Strontium und Kupfer, von denen mindestens eines wasserlöslich ist, in Gegenwart einer wäßrigen Phase vermischt und das Gemisch eindampft.

9. Verfahren nach Anspruch 8, dadurch gekennzeichnet, daß man zu den Salzen von Wismut, Strontium und Kupfer in Gegenwart einer wäßrigen Phase eine Base gibt und ein Metallhydroxid ausfällt, und man den unlöslichen Teil des Ansatzes abtrennt und trocknet.

10. Verfahren nach Anspruch 8, dadurch gekennzeichnet, daß die eingesetzten Salze sich von leicht flüchtigen Säuren ableiten.

11. Verfahren nach Anspruch 7, dadurch gekennzeichnet, daß man das längere Zeit auf Temperaturen von 700-1100°C aufgeheizte Gemisch isoliert, zerkleinert, vermischt und in einem Temperaturbereich von 400 bis 900°C erneut für längere Zeit erhitzt.

12. Verfahren nach Anspruch 7 oder 11, dadurch gekennzeichnet, daß man in einer Atmosphäre erhitzt. die freien Sauerstoff enthält.

**Patentansprüche für folgenden Vertragsstaat : ES**

1. Verfahren zur Herstellung eines supraleitenden Produktes mit einer Sprungtemperatur $T_c$ über 20 K, wobei man die Oxide von Wismut, Strontium und Kupfer oder entsprechende Oxidvorläufer vermischt oder Salze dieser Elemente, von denen mindestens eines wasserlöslich ist, in Gegenwart einer wässrigen Phase vermischt und den Ansatz eindampft, das Gemisch auf Temperaturen von 700-1100°C aufheizt und längere Zeit in diesem Temperaturbereich hält, dadurch gekennzeichnet, daß das eingesetzte Gemisch, bezogen auf den Metallanteil, 36-55,7 Atom-% Wismut, 9,8-49,6 Atom-% Strontium und 10-40 Atom-% Kupfer enthält, wobei die Summe dieser Anteile 100% beträgt.

2. Verfahren nach Anspruch 1, dadurch gekennzeichnet, daß man ein Gemisch einsetzt, das 37-46 Atom-% Wismut enthält, bezogen auf den Metallanteil.

3. Verfahren nach Anspruch 1 oder 2, dadurch gekennzeichnet, daß man ein Gemisch einsetzt, das 14-49,6 Atom-% Strontium enthält, bezogen auf den Metallanteil.

4. Verfahren nach Anspruch 1, dadurch gekennzeichnet, daß man ein Gemisch einsetzt, in dem das Atomverhältnis (Bi + Sr):Cu = 2:0, 95-2:1,05 und das Atomverhältnis Bi:Sr = 19:1 bis 1,5:1 beträgt.

EP 0 317 877 B1

**5.** Verfahren nach Anspruch 4, dadurch gekennzeichnet, daß das Atomverhältnis (Bi + Sr):Cu = 2:1 beträgt.

**6.** Verfahren nach Anspruch 1, dadurch gekennzeichnet, daß man ein Gemisch einsetzt, bei dem das Atomverhältnis Bi:(Sr + Cu) = 2:2,95-2:3,05 und das Atomverhältnis Bi:Sr = 2:1-2:2,5, insbesondere 2:1,333-2,25, beträgt.

**7.** Verfahren nach Anspruch 6, dadurch gekennzeichnet, daß das Atomverhältnis Bi:Sr = 2:1,5-2:2,05, beträgt.

**8.** Verfahren nach Anspruch 6 oder 7, dadurch gekennzeichnet, daß das Atomverhältnis Bi:(Sr + Cu) = 2:3 beträgt.

**9.** Verfahren nach Anspruch 1, dadurch gekennzeichnet, daß man ein Gemisch der Salze von Bi, Sr und Cu in Gegenwart einer wäßrigen Phase einsetzt, hierzu ein Base gibt und so mindestens ein Metallhydroxid ausfällt, man den unlöslichen Anteil abtrennt, trocknet und bei Temperaturen von 700 bis 1100°C längere Zeit erhitzt.

**10.** Verfahren nach Anspruch 1, dadurch gekennzeichnet, daß die eingesetzten Salze von Bi, Sr und Cu sich von leicht flüchtigen Säuren ableiten.

**11.** Verfahren nach Anspruch 1, dadurch gekennzeichnet, daß man das isolierte getemperte Gemisch zerkleinert, vermischt und in einem Temperaturbereich von 400 bis 900°C erneut für längere Zeit erhitzt.

**12.** Verfahren nach Anspruch 1 oder 11, dadurch gekennzeichnet, daß man in einer Atmosphäre erhitzt, die freien Sauerstoff enthält.

**Claims**
**Claims for the following Contracting States : AT, BE, CH, DE, FR, GB, GR, IT, LI, LU, NL, SE**

**1.** A black crystal composition having the empirical composition

$$Bi_a Sr_b Cu_c O_d$$

where
a + b + c = 1,
a = 0.36 - 0.557, in particular 0.37 - 0.46,
b = 0.098 - 0.496, in particular 0.14 - 0.496,
c = 0.1 - 0.4 and
d = about 1 + a/2 and
having a critical temperature $T_c$ for superconductivity of greater than 20 K and a principal phase which crystallizes in the orthorhombic system.

**2.** A crystal composition as claimed in claim 1, having the empirical composition
$Bi_{1.2 + x} Sr_{0.8-x} Cu_{1 + k} O_e$, where
k is a number between -0.05 and +0.05,
x is a number between 0 and 0.7 and
e is approximately 3.6 + k + x/2.

**3.** A crystal composition as claimed in claim 2, wherein k = 0.

**4.** A crystal composition as claimed in claim 1, having the empirical composition $Bi_2 Sr_y Cu_{3-y + k} O_f$, where
k denotes a number between -0.05 and +0.05 and
y denotes a number between 1 and 2.5, preferably 1.33 and 2.25, and
f is approximately 6 + k.

**5.** A crystal composition as claimed in claim 4, where y denotes a number between 1.5 and 2.05.

7

EP 0 317 877 B1

**6.** A crystal composition as claimed in claim 4, wherein k = 0.

**7.** A process for the preparation of a superconducting product having a critical temperature $T_c$ of above 20 K, in which the oxides of bismuth, strontium and copper or corresponding oxide precursors are mixed, the mixture is heated to temperatures of 700-1100°C and kept in this temperature range for an extended period, wherein the mixture employed contains, based on the metal content, 36-55.7 atom-% of bismuth, 9.8-49.6 atom-% of strontium and 10-40 atom-% of copper, the sum of these proportions being 100 %.

**8.** The process as claimed in claim 7, wherein, in order to prepare a mixture of the oxide precursors, salts of bismuth, strontium and copper, of which at least one is water-soluble, are mixed in the presence of an aqueous phase, and the mixture is evaporated.

**9.** The process as claimed in claim 8, wherein a base is added to the salts of bismuth, strontium and copper in the presence of an aqueous phase, a metal hydroxide is precipitated, and the insoluble part of the batch is separated off and dried.

**10.** The process as claimed in claim 8, wherein the salts employed are derived from readily volatile acids.

**11.** The process as claimed in claim 7, wherein the mixture heated for an extended period at 700-1100°C is isolated, comminuted, mixed and re-heated in a temperature range of from 400 to 900°C for an extended period.

**12.** The process as claimed in claim 7 or 11, wherein the heating is carried out in an atmosphere containing free oxygen.

**Claims for the following Contracting State : ES**

**1.** A process for the preparation of a superconducting product having a critical temperature $T_c$ of above 20 K, in which the oxides of bismuth, strontium and copper or corresponding oxide precursors are mixed, or salts of these elements, of which at least one is water-soluble, are mixed in the presence of an aqueous phase and the batch is evaporated, the mixture is heated to temperatures of 700-1100°C and kept in this temperature range for an extended period, wherein the mixture employed contains, based on the metal content, 36-55.7 atom-% of bismuth, 9.8-49.6 atom-% of strontium and 10-40 atom-% of copper, the sum of these proportions being 100 %.

**2.** The process as claimed in claim 1, wherein a mixture is employed which contains 37-46 atom-% of bismuth, based on the metal content.

**3.** The process as claimed in claim 1 or 2, wherein a mixture is employed which contains 14-49.6 atom-% of strontium, based on the metal content.

**4.** The process as claimed in claim 1, wherein a mixture is employed in which the (Bi + Sr):Cu atomic ratio is from 2:0.95-2:1.05, and the Bi:Sr atomic ratio is from 19:1 to 1.5:1.

**5.** The process as claimed in claim 4, wherein the (Bi + Sr):Cu atomic ratio is 2:1.

**6.** The process as claimed in claim 1, wherein a mixture is employed in which the Bi:(Sr + Cu) atomic ratio is from 2:2.95-2:3.05, and the Bi:Sr atomic ratio is from 2:1-2:2.5, in particular from 2:1.333-2.25.

**7.** The process as claimed in claim 6, wherein the Bi:Sr atomic ratio is from 2:1.5-2:2.05.

**8.** The process as claimed in claim 6 or 7, wherein the Bi:(Sr + Cu) atomic ratio is 2:3.

**9.** The process as claimed in claim 1, wherein a mixture of salts of Bi, Sr and Cu is employed in the presence of an aqueous phase, a base is added thereto and at least one metal hydroxide is precipitated in this way, and the insoluble content is separated off, dried and heated for an extended period at temperatures of from 700 to 1100°C.

8

EP 0 317 877 B1

**10.** The process as claimed in claim 1, wherein the salts of Bi, Sr and Cu which are employed are derived from readily volatile acids.

**11.** The process as claimed in claim 1, wherein the isolated, conditioned mixture is comminuted, mixed and re-heated in a temperature range of from 400 to 900°C for an extended period.

**12.** The process as claimed in claim 1 or 11, wherein the heating is carried out in an atmosphere containing free oxygen.

**Revendications**
**Revendications pour les Etats contractants suivants : AT, BE, CH, DE, FR, GB, GR, IT, LI, LU, NL, SE**

**1.** Masse cristalline noire ayant pour formule brute :

$Bi_aSr_bCu_cO_d$

dans laquelle $a+b+c = 1$,
$a = 0,360 - 0,557$, en particulier $0,37 - 0,46$,
$b = 0,098 - 0,496$, en particulier $0,14 - 0,496$,
$c = 0,1 - 0,4$ et
$d \approx 1 + a/2$,
une température critique $T_c$ de supraconductivité supérieure à 20 K et une phase principale qui cristallise dans le système orthorhombique.

**2.** Masse cristalline selon la revendication 1, caractérisée par la formule brute : $Bi_{1,2+x}Sr_{0,8-x}Cu_{1+k}O_e$ dans laquelle
$k$ est un nombre compris entre $-0,05$ et $+0,05$,
$x$ est un nombre compris entre 0 et 0,7 et
$e$ vaut à peu près $3,6+k+x/2$.

**3.** Masse cristalline selon la revendication 2, caractérisée en ce que $k = 0$.

**4.** Masse cristalline selon la revendication 1, caractérisée par la formule brute : $Bi_2Sr_yCu_{3-y+k}O_f$ dans laquelle
$k$ est un nombre compris entre $-0,05$ et $+0,05$,
$y$ est un nombre compris entre 1 et 2,5, de préférence entre 1,33 et 2,25 et
$f$ vaut à peu près $6 + k$.

**5.** Masse cristalline selon la revendication 4, dans laquelle $y$ est un nombre compris entre 1,5 et 2,05.

**6.** Masse cristalline selon la revendication 4, caractérisée en ce que $k = 0$.

**7.** Procédé pour fabriquer un matériau supraconducteur présentant une température critique $T_c$ supérieure à 20 K, dans lequel on mélange les oxydes de bismuth, de strontium et de cuivre ou bien les précurseurs correspondants à ces oxydes, on chauffe le mélange à des températures comprises entre 700°C et 1100°C et on le maintient assez longtemps dans ce domaine de température, procédé caractérisé en ce que le mélange utilisé contient, par rapport à sa fraction métallique, de 36 à 55,7% de bismuth en pourcentage atomique, de 9,8 à 49,6% de strontium en pourcentage atomique et de 10 à 40% de cuivre en pourcentage atomique, la somme de ces teneurs étant égale à 100%.

**8.** Procédé selon la revendication 7, caractérisé en ce que, pour préparer un mélange des précurseurs d'oxydes, on mélange, en présence d'une phase aqueuse, des sels de bismuth, de strontium et de cuivre dont l'un au moins est soluble dans l'eau et en ce que l'on concentre le mélange par évaporation.

**9.** Procédé selon la revendication 8, caractérisé en ce que l'on ajoute une base aux sels de bismuth, de strontium et de cuivre en présence d'une phase aqueuse, ce qui a pour effet de faire précipiter un hydroxyde métallique, on sépare la partie insoluble du mélange et on la sèche.

9

**10.** Procédé selon la revendication 8, caractérisé en ce que les sels utilisés proviennent d'acides volatils.

**11.** Procédé selon la revendication 7, caractérisé en ce que l'on isole le mélange qui a été chauffé pendant une assez longue durée à des températures comprises entre 700 et 1100°C, on le broie, on le mélange et on le chauffe à nouveau pendant une assez longue durée dans une gamme de température allant de 400 à 900°C.

**12.** Procédé selon la revendication 7 ou 11, caractérisé en ce que l'on chauffe le mélange dans une atmosphère qui contient de l'oxygène à l'état libre.

**Revendications pour l'Etat contractant suivant : ES**

**1.** Procédé pour fabriquer un matériau supraconducteur présentant une température critique $T_c$ supérieure à 20 K, selon lequel on mélange les oxydes de bismuth, de strontium et de cuivre ou bien des précurseurs correspondants à ces oxydes, ou on mélange, en présence d'une phase aqueuse, des sels de ces éléments dont un au moins est soluble dans l'eau et on concentre le tout par évaporation, on chauffe le mélange à des températures comprises entre 700 et 1100°C et on le maintient assez longtemps dans ce domaine de températures, procédé caractérisé en ce que le mélange utilisé contient, par rapport à sa fraction métallique, de 36 à 55,7% de bismuth en pourcentage atomique, de 9,8 à 49,6% de strontium en pourcentage atomique et de 10 à 40% de cuivre en pourcentage atomique, la somme de ces teneurs étant égale à 100%.

**2.** Procédé selon la revendication 1, caractérisé en ce que l'on utilise un mélange qui contient de 37 à 46% de bismuth en pourcentage atomique, par rapport à sa fraction métallique.

**3.** Procédé selon la revendication 1 ou 2, caractérisé en ce que l'on utilise un mélange qui contient de 14 à 49,6% de strontium en pourcentage atomique, par rapport à sa fraction métallique.

**4.** Procédé selon la revendication 1, caractérisé en ce que l'on utilise un mélange dans lequel le rapport atomique (Bi + Sr):Cu vaut de 2:0,95 à 2:1,05 et dans lequel le rapport atomique Bi:Sr vaut de 19:1 à 1,5:1.

**5.** Procédé selon la revendication 4, caractérisé en ce que le rapport atomique (Bi + Sr):Cu vaut 2:1.

**6.** Procédé selon la revendication 1, caractérisé en ce que l'on utilise un mélange dans lequel le rapport atomique Bi:(Sr + Cu) vaut de 2:2,95 à 2:3,05 et dans lequel le rapport atomique Bi:Sr vaut de 2:1 à 2:2,5, en particulier de 2:1,333 à 2:2,25.

**7.** Procédé selon la revendication 6, caractérisé en ce que le rapport atomique Bi:Sr vaut de 2:1,5 à 2:2,05.

**8.** Procédé selon la revendication 6 ou 7, caractérisé en ce que le rapport atomique Bi:(Sr + Cu) vaut 2:3.

**9.** Procédé selon la revendication 1, caractérisé en ce que l'on utilise un mélange de sels de Bi, Sr et Cu en présence d'une phase aqueuse, on y ajoute une base et on fait ainsi précipiter au moins un hydroxyde métallique, on sépare la partie insoluble, on la sèche et on la chauffe à des températures allant de 700 à 1100°C pendant une assez longue durée.

**10.** Procédé selon la revendication 1, caractérisé en ce que les sels de Bi, Sr et Cu utilisés proviennent d'acides volatils.

**11.** Procédé selon la revendication 1, caractérisé en ce que l'on isole le mélange, on le broie, on le mélange et on le chauffe à nouveau pendant une assez longue durée dans une gamme de température- allant de 400 à 900°C.

**12.** Procédé selon la revendication 1 ou 11, caractérisé en ce que l'on chauffe le mélange dans ne atmosphère qui contient de l'oxygène à l'état libre.